# EUROPEAN PATENT SPECIFICATION

(11) **EP 2 775 811 B1**
(45) Date of publication and mention of the grant of the patent: **10.05.2017**
(21) Application number: 12846259.5
(22) Date of filing: 10.10.2012
(51) Int. Cl.: H05K 13/04

(54) **TAPE FEEDER**
BANDZUFÜHRUNG
MÉCANISME D'ALIMENTATION DE BANDE

(30) Priority: 01.11.2011 JP 2011240134
(43) Date of publication of application: 10.09.2014
(73) Proprietor: Fuji Machine Mfg. Co., Ltd., Chiryu-shi, Aichi 472-8686 (JP)
(72) Inventor: KUNIHIRO, Tsutomu, Chiryu-shi Aichi 472-8686 (JP); TAKADA, Yukinori, Chiryu-shi Aichi 472-8686 (JP)
(74) Representative: Grünecker Patent- und Rechtsanwälte PartG mbB
(86) International application number: PCT/JP2012/076181
(87) International publication number: WO 2013/065458

(56) References cited:
- EP-A1- 1 147 697
- EP-A1- 1 438 884
- WO-A1-2006/126465
- JP-A- 2002 533 944
- JP-A- 2005 503 677
- JP-A- 2008 130 851
- JP-A- 2010 040 901
- JP-A- 2010 040 901

## Description

### TECHNICAL FIELD

The present invention relates to a tape feeder with a construction such that tape suppliers, on which component supply tape in which multiple electronic components are arranged at a specific pitch is set in order to supply the components to a pickup position, are removably attached to the feeder main body.

### BACKGROUND TECHNOLOGY

Conventional tape feeders, as disclosed in Prior Art 1 (Japanese Unexamined Patent Application Publication Number 2010-109109), index electronic component supply tape to a component pickup position by rotating a sprocket, the teeth of which are engaged with sprocket holes which are arranged at a specific pitch along the edge of component supply tape, such that components in the component supply tape can be picked up by a suction nozzle of an electronic component mounter at a component pickup position.

The work of setting component supply tape on this type of tape feeder comprises removing the tape feeder from the electronic component mounter, setting the reel of the component supply tape on the tape feeder, and engaging the sprocket holes of the component supply tape pulled out from the reel with the sprocket teeth.

However, with the configuration given in Prior Art 1 above, the work of setting component supply tape onto the tape feeder is troublesome, so in Prior Art 2 applied for by the same applicant (Japanese Unexamined Patent Application Publication Number 2011-138834), as well a tape supplier used to supply component supply tape from a tape reel to a component pickup position being attachable to and removable from the feeder main body, there is a lever mechanism for raising and lowering the sprocket moving unit used to index the component supply tape to the component pickup position, so that when the tape supplier is removed from or attached to the feeder main body the operator operates the lever mechanism to lower the sprocket moving unit to a retract position at which the teeth of the sprocket of the sprocket moving unit are lower than the sprocket holes; and after the tape supplier has been attached to the feeder main body, the operator operates the lever mechanism to raise the sprocket moving unit to an engagement position so that the teeth of the sprocket of the sprocket moving unit are engaged with the sprocket holes in the component supply tape.

### PRIOR ART REFERENCES

### PRIOR ART

Prior Art 1: Japanese Unexamined Patent Application Publication Number 2010-109109
Prior Art 1: Japanese Unexamined Patent Application Publication Number 2011-138834

### BRIEF SUMMARY OF THE INVENTION

### PROBLEM SOLVED BY INVENTION

However, with a configuration in which a tape supplier is attachable to and removable from a feeder main body it is necessary to manage the identification information of tape suppliers and the identification information of feeder main bodies separately; but in Prior Art 2, there is no mention of the management method for this identification information.

The document JP 2010-040901 A discloses a feeder for electronic component supplies having a reel receiving part for accommodating reels. Each reel has a winding part on which a tape is wound. The reel receiving part is provided with an antenna section adapted to read information stored on an RFID tag stuck on the reel.
From EP 1 147 697 A1 a method of transferring component tape information to a component mounting machine is known. A tape guide for guiding a component tape is provided with a bar code read by a bar code reader when the component tape is loaded into the tape guide The tape guide is further equipped with an identification circuit adapted to be connected with an identity receiving circuit located in a tape guide magazine.
EP 1 438 884 A1 discloses an arrangement for handling component tapes in connection with mounting components onto circuit boards in a component mounting machine, which utilizes a carrier for carrying component tapes. Each component tape is held by a component tape reel. Thecomponent mounting machine utilizes component magazines from which components, carried by the component tape are supplied for use in a mounting process of the component mounting machine. The component tape of each component tape reel is loaded into a tape guide for guiding the component tape in the component mounting machine. The component tape reels are arranged in the carrier, which is placed in the magazine. The tape guide are then mounted in the magazine such that the component tape loaded therein may interact with feeding devices provided in the magazine.
From WO 2006/126465 A1 a carrier tape package is known used in an electronic components placing apparatus for feeding electric components by a tape feeder, and has a carrier tape housed in a wound state on a tape reel. In the carrier tape package, a data storage unit, in which an IC tag having carrier tape information containing identification information of electronic components held in the carrier tape is held in a holder, is attached to the tape reel. At the instant when the carrier tape is mounted in the tape feeder, the carrier information is read out by a reader/writer belonging to the tape feeder from the data storage unit mounted on the leading end portion of the tape feeder.
With respect to this, for the problem to be solved by this invention, what is proposed is a tape feeder which can automatically manage tape supplier identification information.

### MEANS OF SOLVING THE PROBLEM

This object is solved by the features of claim 1. Further improvements are laid down in the sub-claims. The present invention has a configuration in which, for a tape feeder configured such that a tape supplier which supplies component supply tape to a component pickup position is removably attached to a feeder main body, the tape suppliers are equipped with a supplier identification information memorizing means in which the tape supplier identification information (hereafter referred to as "supplier ID") is memorized, and the feeder main body is equipped with an identification information reading and memorizing means for reading the supplier ID from the supplier identification information memorizing means of the tape supplier attached to the feeder main body; also, the feeder main body being equipped with an attachment recognition means to recognize when a tape supplier has been attached to the feeder main body by reading the supplier ID from the supplier identification information memorizing means using the identification information reading and memorizing means.

With this configuration, because the identification information reading and memorizing means on the feeder main body can read the supplier ID from the supplier identification information memorizing means of the tape supplier, the supplier ID of a tape supplier attached to the feeder main body can be read automatically, and problems such as tape suppliers being wrongly attached or the wrong supplier ID being entered can be resolved. Furthermore, by the identification information reading and memorizing means reading the supplier ID from the supplier identification information memorizing means, because the feeder main body is equipped with an attachment recognition means to recognize when a tape supplier has been attached to the feeder main body, the signal of the supplier ID read by the identification information reading and memorizing means of the feeder main body can also be used as the signal for checking for the attachment of the tape supplier. By this, it is not necessary to equip the feeder main body with items such as sensors for recognizing the attachment of tape suppliers, which makes it possible to meet the demands for simplifying and lowering the cost.

In addition, for the present invention it is preferable for the feeder main body to be equipped with a feeder main body identification information memorizing means for memorizing the identification information (hereafter referred to as "feeder main body ID") of the feeder main body; and a communication means for transmitting the supplier ID read by the identification information reading and memorizing means mentioned above and the feeder main body ID read from the feeder main body identification information memorizing means to the electronic component mounter on which the feeder main body is loaded. By doing this, both the supplier ID and feeder main body ID can be managed at the electronic component mounter side.

For the present invention, it is acceptable to have a configuration in which only 1 tape supplier is set on the feeder main body, but it is preferable to have a configuration in which multiple tape suppliers are each independently removably attached to the feeder main body, and for the feeder main body to be equipped with multiple sprocket moving units for indexing component supply tape to a component pickup position for the multiple tape suppliers to be attached, and for each sprocket moving unit to be equipped with a moving unit identification information memorizing means which has memorized the identification information of the sprocket moving unit (hereafter referred to as "the sprocket moving unit ID"), with the communication means mentioned above transmitting the sprocket moving unit ID read from the moving unit identification information memorizing means of the multiple sprocket moving units mentioned above to the electronic component mounter. By doing this, as well as the supplier ID and feeder main body ID, the sprocket moving unit ID can also be managed at the electronic component mounter side.

### BRIEF DESCRIPTION OF THE DRAWINGS

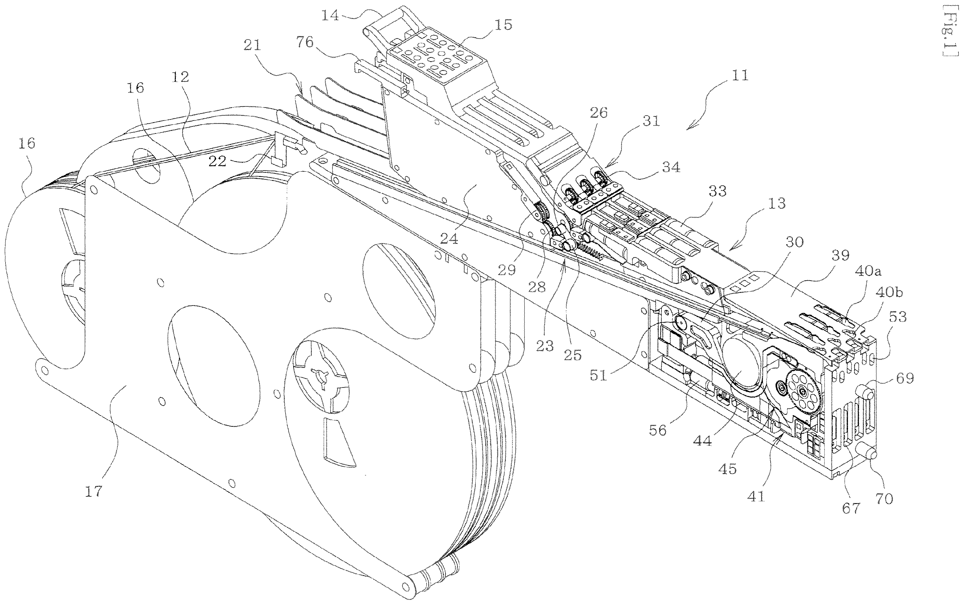

[FIG. 1] FIG. 1 is a perspective view showing the entire tape feeder from an embodiment of the present invention.
[FIG. 2] FIG. 2 is a perspective view of the feeder main body (1).

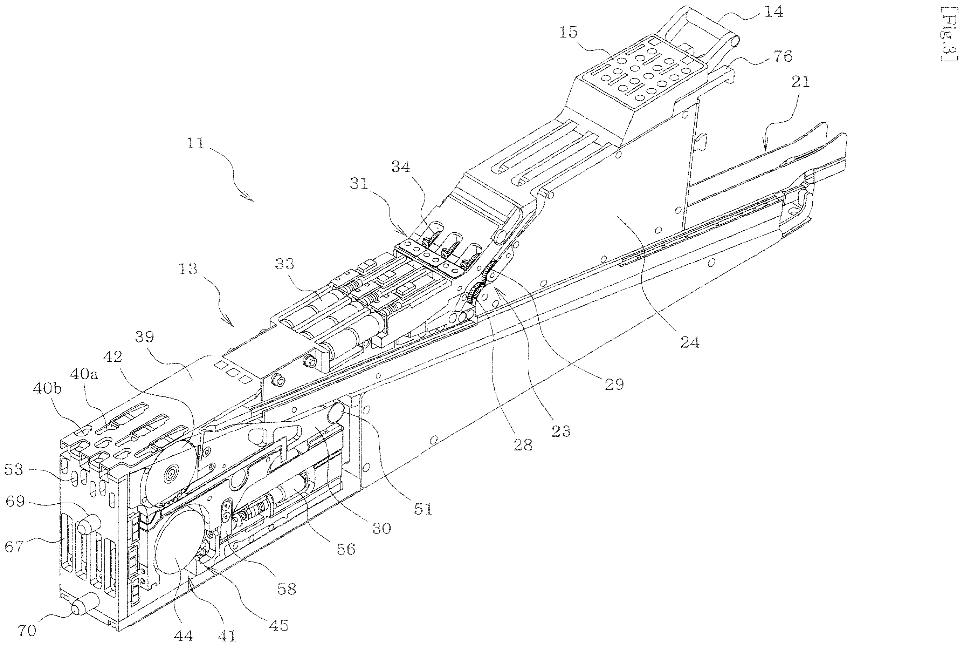

[FIG. 3] FIG. 3 is a perspective view of the feeder main body (2).
[FIG. 4] FIG. 4 is a perspective view of a tape supplier.
[FIG. 5] FIG. 5 is a perspective view showing the cover tape indexing gear moving device and surrounding section (1).
[FIG. 6] FIG. 6 is a perspective view showing the cover tape indexing gear moving device and surrounding section (2).
[FIG. 7] FIG. 7 is a perspective view of the end section of the feeder main body.
[FIG. 8] FIG. 8 is a perspective view showing the end section of the feeder main body with the end cover plate removed.
[FIG. 9] FIG. 9 is a perspective view of two sprocket moving units (1).
[FIG. 10] FIG. 10 is a perspective view of two sprocket moving units (2).

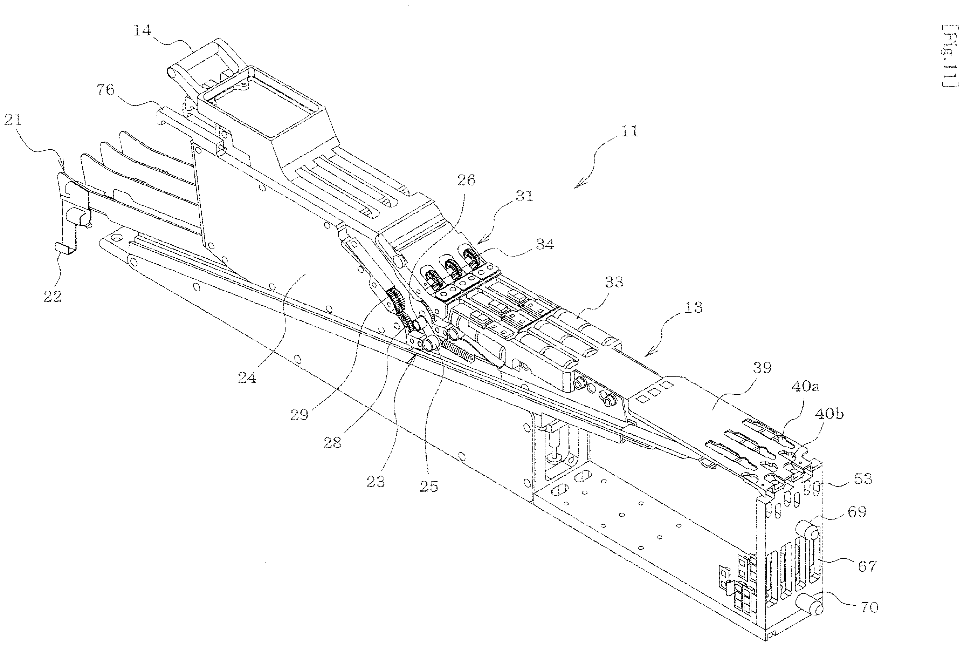

[FIG. 11] FIG. 11 is a perspective view showing the feeder main body with the sprocket moving units removed.
[FIG. 12] FIG. 12 is a perspective view showing the attachment configuration of the sprocket moving units to the feeder main body.

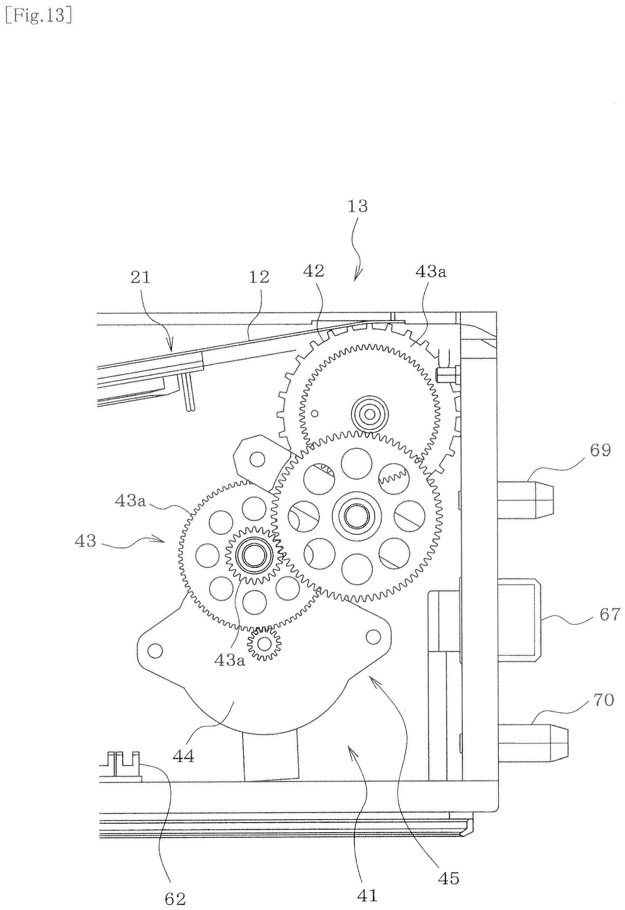

[FIG. 13] FIG. 13 is a right side view showing the configuration of the device for moving the sprocket.
[FIG. 14] FIG. 14 is a left side view showing the configuration of the device for moving the sprocket.
[FIG. 15] FIG. 15 is an enlarged cross-section view showing the configuration for supporting each cog of the spur gear set with bearings.
[FIG. 16] FIG. 16 is a perspective view of the feeder loading table of the electronic component mounter.
[FIG. 17] FIG. 17 is a perspective view showing the configuration of the underside of the operation panel of the feeder main body.
[FIG. 18] FIG. 18 is an enlarged perspective view of the tape supplier handle and the surrounding sections.
[FIG. 19] FIG. 19 is a block diagram showing the configuration of the tape feeder control items.
[FIG. 20] FIG. 20 is a flowchart showing the flow of processing of the automatic engagement operation control program.

### MODE FOR CARRYING OUT THE INVENTION

The following uses figures to describe a specific embodiment used to carry out the present invention. First, the configuration of tape feeder 11 is described.

Tape feeder 11 is constructed so that feeder main body 13 has a width that is an approximate multiple of the width of a standard tape feeder (a tape feeder on which only 1 component supply tape can be set), so that multiple component supply tape 12 can be set widthwise next to each other. In this embodiment, by making the gap between adjacent component supply tapes 12 small, the width of feeder main body 13 is about 4 times (about M times), for example, the width of a standard tape feeder, which means the configuration is such that 6 (N, where N is an integer large than M) component supply tapes 12 can be set widthwise next to each other. The figures do not show the details, but component supply tape 12 has carrier tape with components stored in component storage cavities formed in a line at a given pitch, top tape (also known as cover tape) attached to the upper surface of the carrier tape, and sprocket holes (not shown) formed in a line at a given pitch along the edge of component supply tape 12.

The upper section of the rear side (the removal side) of feeder main body 13 is equipped with handle 14 and operation panel 15, and the underside is equipped with reel holder 17 for storing tape reel 16 on which component supply tape 12 is wound. Reel holder 17 is formed such that multiple tape reels 16 can be arranged in 2 rows front and back, and each tape reel 16 is stored so that it can be rotated within reel holder 17 based on the unwinding of component supply tape 12. Operation panel 15 is equipped with items such as operation keys for inputting each type of operation signal such as the tape supplier attachment work start signal to each sprocket moving unit 41 (each tape supplier 21) which is described below.

Each component supply tape 12 unwound from tape reel 16 is supplied to the component pickup position by tape supplier 21. Each tape supplier 21 is configured such that it is removably attached to feeder main body 13, and so that only 1 of each component supply tape 12 can be set on each tape supplier 21, and the width of each tape supplier 21 is slightly larger than the width of component supply tape 12.

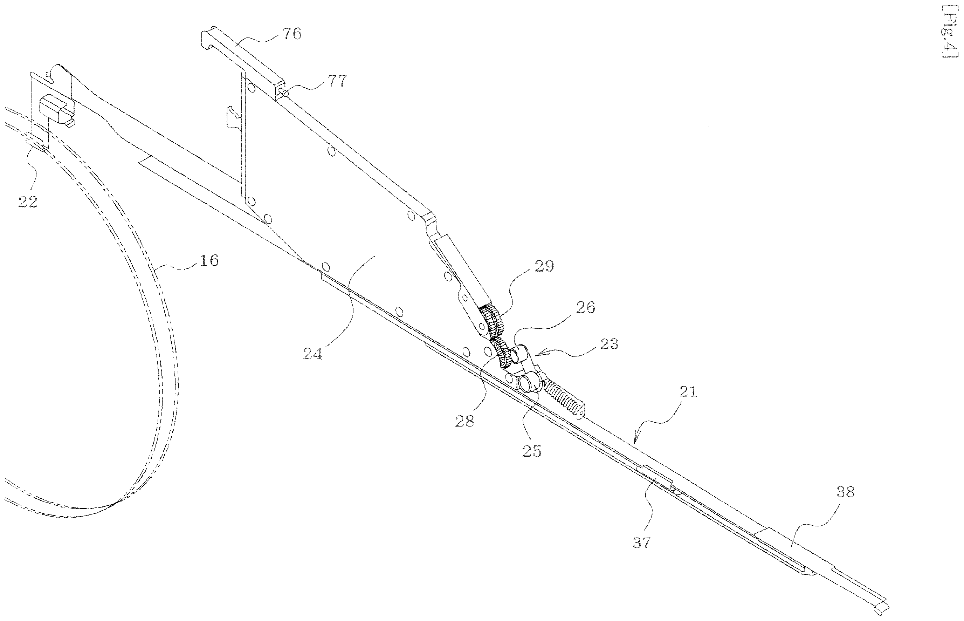

As shown in FIG. 4, the rear end of each tape supplier 21 is equipped with a reel hook 22 for holding tape reel 16 when tape supplier 21 is removed from feeder main body 13, and tape reel 16 can be held on reel hook 22.

Tape supplier 21 is equipped with cover tape peeling device 23 for peeling away the cover tape which covers the upper surface of component supply tape 12, and cover tape collection case 24 for collecting cover tape peeled from component supply tape 12. Cover tape peeling device 23 comprises peeling roller 25, tension roller 26, a pair of cover tape indexing gears 28 and 29, such that cover tape peeled with peeling roller 25 is fed to tension roller 26, then between cover tape indexing gears 28 and 29, and then fed into cover tape collection case 24.

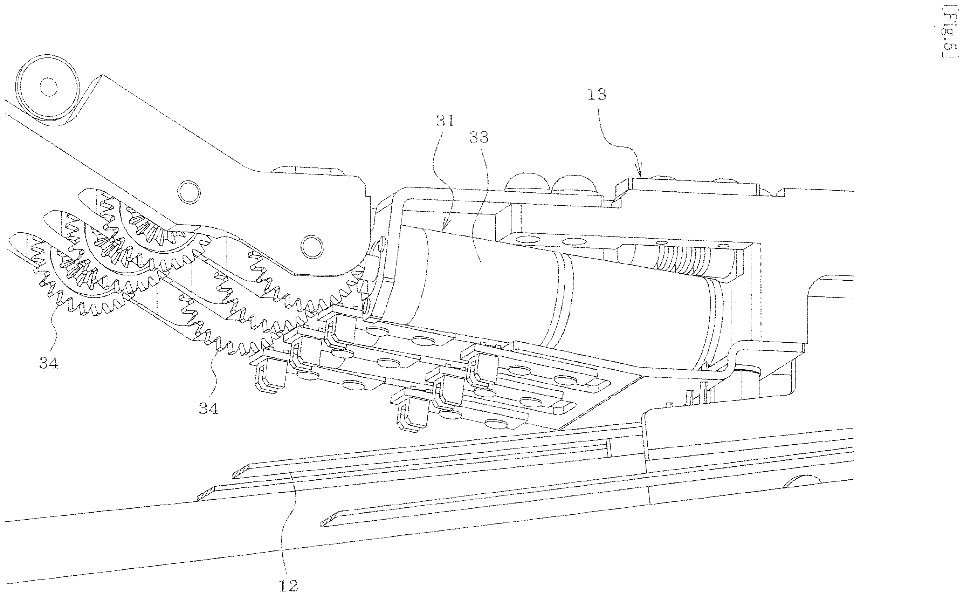

The moving power for cover tape indexing gears 28 and 29 is set on feeder main body 13, and when tape supplier 21 is attached to feeder main body 13, one of the cover tape indexing gears 28 engages with moving gear 34 (refer to FIG. 5) on feeder main body 13 so that both cover tape indexing gears 28 and 29 are rotated.

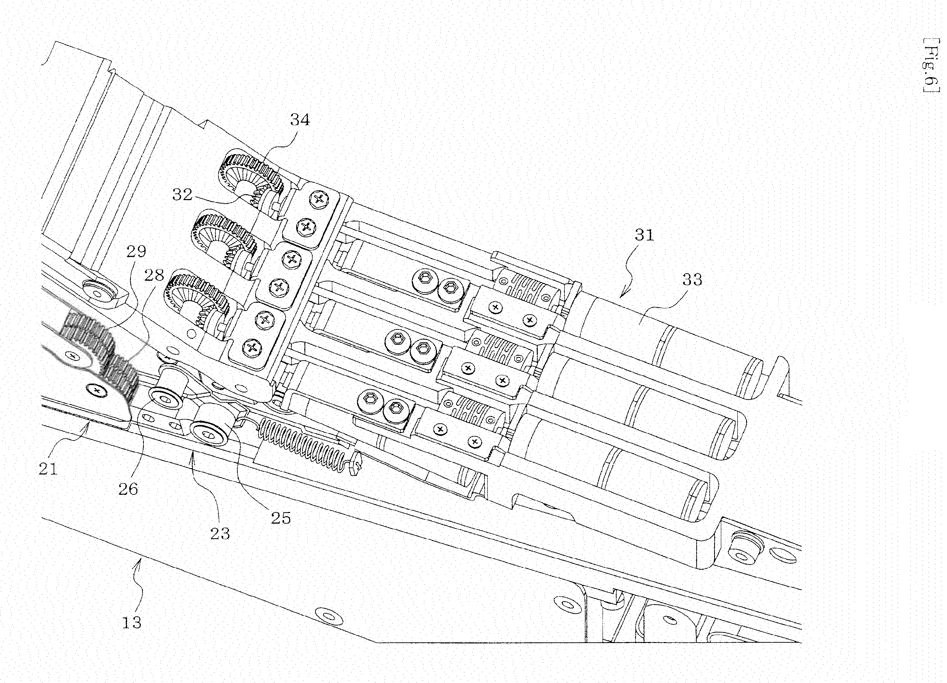

Moving device 31 for moving cover tape indexing gears 28 and 29 is set in the space above where tape supplier 21 is attached to feeder main body 13. This moving device 31 is equipped with motor 33 for rotating bevel gear 32 (refer to FIG. 6) and moving gear 34 which is rotated by bevel gear 32, with this moving gear 34 engaging with one of the cover tape indexing gears 28, by which both cover tape indexing gears 28 and 29 are rotated. The same number of each of motor 33, bevel gear 32, and moving gear 34 are equipped as the number of tape suppliers 21 which can be attached to feeder main body 13; with the amount that the cover tape is indexed (the amount peeled off) being able to be controlled independently for each tape supplier 21.

As shown in FIG. 4, on tape supplier 21, multiple C-shaped tape retainers 37 and 38 which support component supply tape 12 from one side only are arranged so that one supports component supply tape 12 from one side while the other supports it from the other side in an alternating zig-zag pattern; this slightly contorts component supply tape 12 widthwise (or tilts it diagonally) while supporting it, with each tape retainer 37 and 38 arranged slightly offset within the width of component supply tape 12, meaning that the component supply tape 12 can be supported within a narrower width.

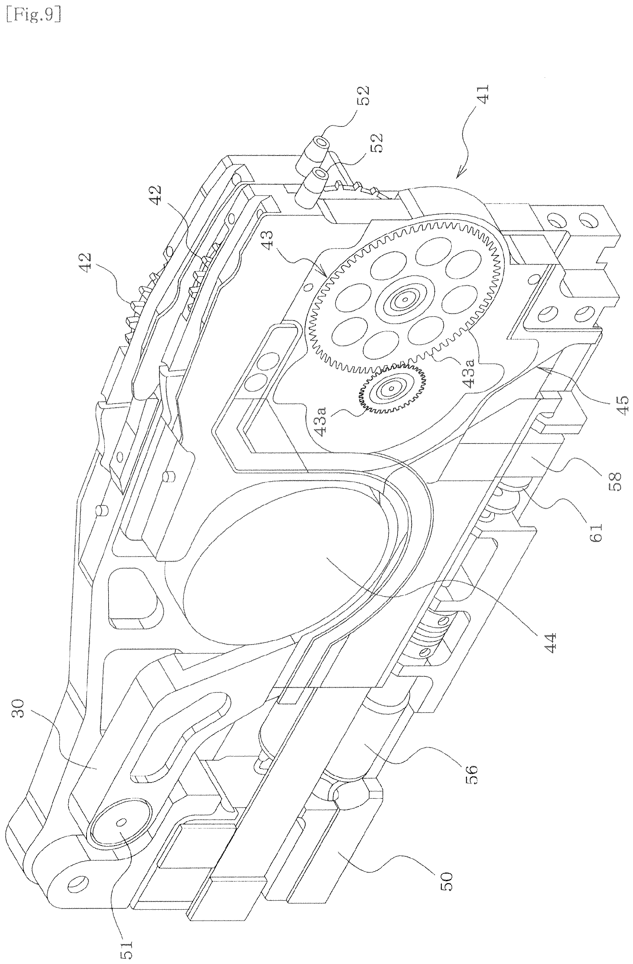

On the end of feeder main body 13, the same number of sprocket moving motors 41 as the number of component supply tapes 12 which can be set on the feeder main body 13 are attached next to each other widthwise. As described below, sprocket moving mechanism 45 of each sprocket moving unit 41 is configured with items such as sprocket 42 and motor 44 for moving sprocket 42 via spur gear set 43 (gear mechanism) attached to raising and lowering lever 30 (refer to FIGS. 9, 10 and 12), with these raised and lowered as one body around axis 51 as a fulcrum. Each sprocket 42 is arranged on feeder body 13 in an appropriate position for each set component supply tape 12, with pitch indexing of component supply tape 12 towards the component pickup position performed by rotating sprocket 42 with the teeth of sprocket 42 engaged in the sprocket holes of each component supply tape 12.

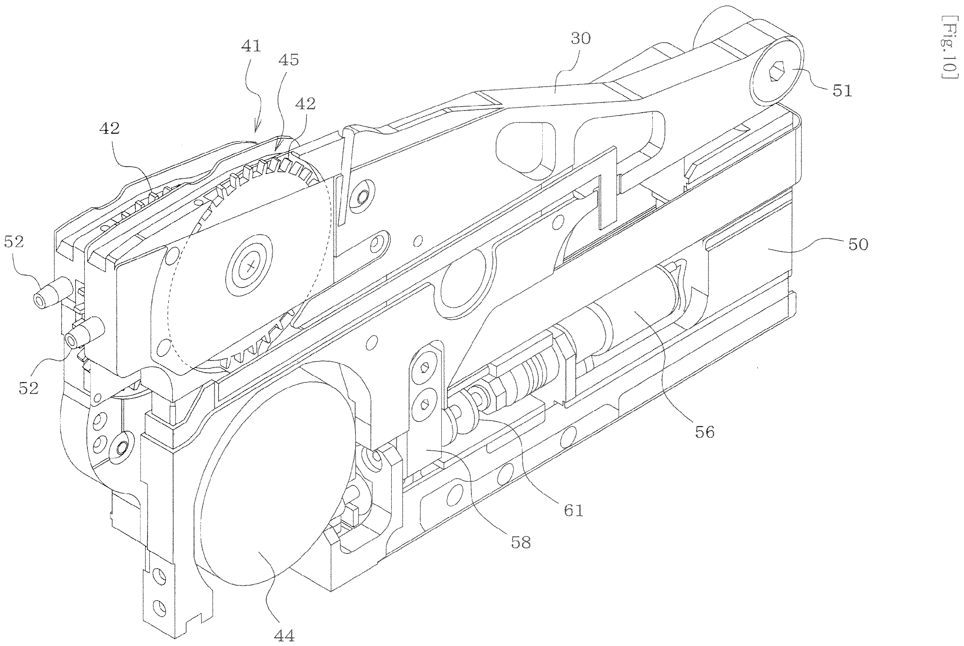

In order to make the width of each sprocket moving unit 41 smaller, as shown in FIGS. 9 and 10, sprocket position 42 of two adjacent sprocket moving units 41 are arranged offset forward/backward from each other, and each cog 43a of spur gear set 43 of two adjacent sprocket moving units 41 are arranged in an offset position, so that the open space of each sprocket moving unit 41 can be used effectively by creating space into which cog 43a of an adjacent sprocket moving unit 41 can protrude.

Sprocket moving mechanism 45 of each sprocket moving unit 41 uses a flat motor (such as a DC servo motor or pulse motor) as motor 44 for moving sprocket 42, with the rotating axis of motor 44 and the axis of sprocket 42 arranged in parallel so that the moving power of motor 44 is transmitted to sprocket 42 by spur gear set 43. By using this configuration, backlash adjustment is easy, countermeasures for thrust load are unnecessary, as well as the benefit of reduced costs due to the processing of parts being easy.

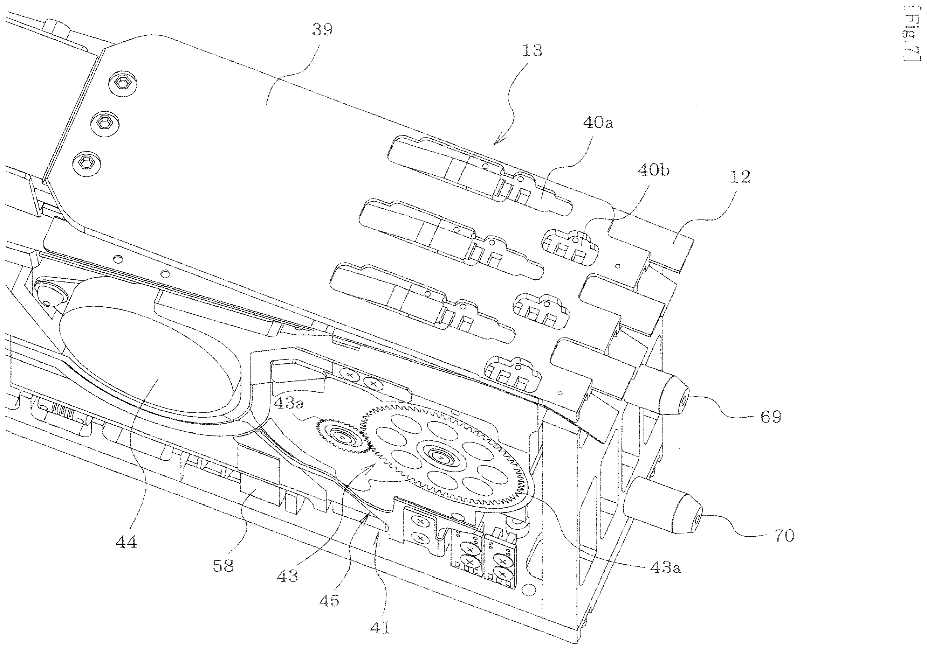

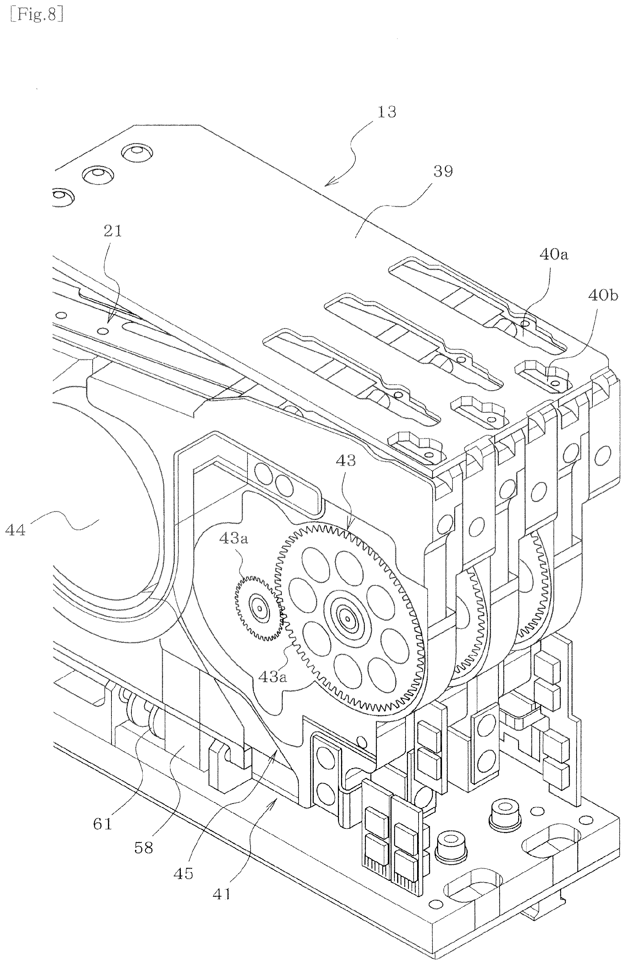

As shown in FIGS. 7 and 8, on top cover plate 39 which covers above sprocket moving units 41 within feeder body 13, component pickup openings 40a and 40b are arranged in a zig-zag pattern as openings for component pickup positions at which components in component supply tape 12 are picked up by suction nozzles of an electronic component mounter. In this embodiment, a total of 6 component supply tapes 12 can be attached to feeder body 13, so there are a total of 6 component pickup openings 40a and 40b.

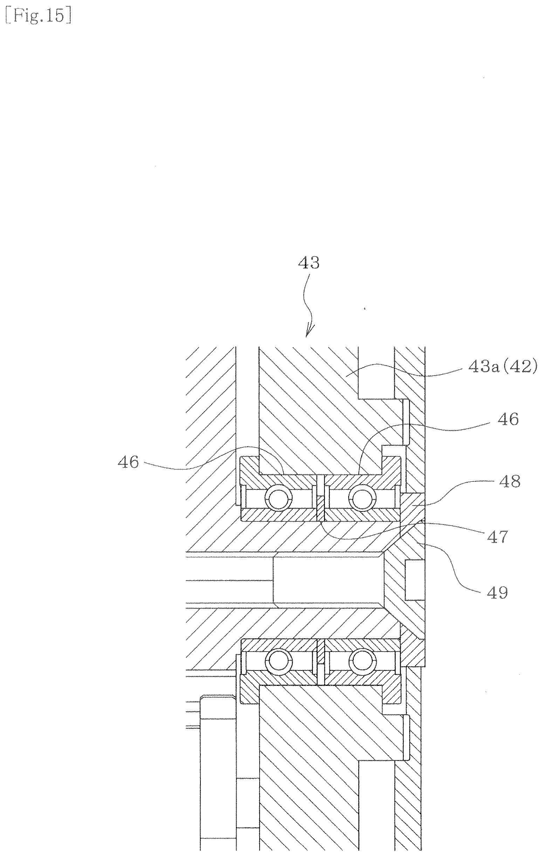

As shown in FIG. 15, as well as both each cog 43a of spur gear set 43 and sprocket 42 being supported for free rotation by 2 bearings 46, between the 2 bearings 46 elastic material 47 such as rubber or spring washer are introduced, with bearing retainer 48, used to stop the inner side of bearings 46 falling out, secured with screw 49 to compress elastic material 47, this configuration applying the appropriate precompression to bearings 46. This configuration means that the rotational transmission of each cog 43a of spur gear set 43 and sprocket 42 can be smoother, as well as being able to protect against a deterioration in rotational accuracy due to vibration and movement of cogs 43a.

Next, the following describes the configuration of the raising and lowering mechanism for independently raising and lowering each of the sprocket moving mechanism 45 of each sprocket moving unit 41.

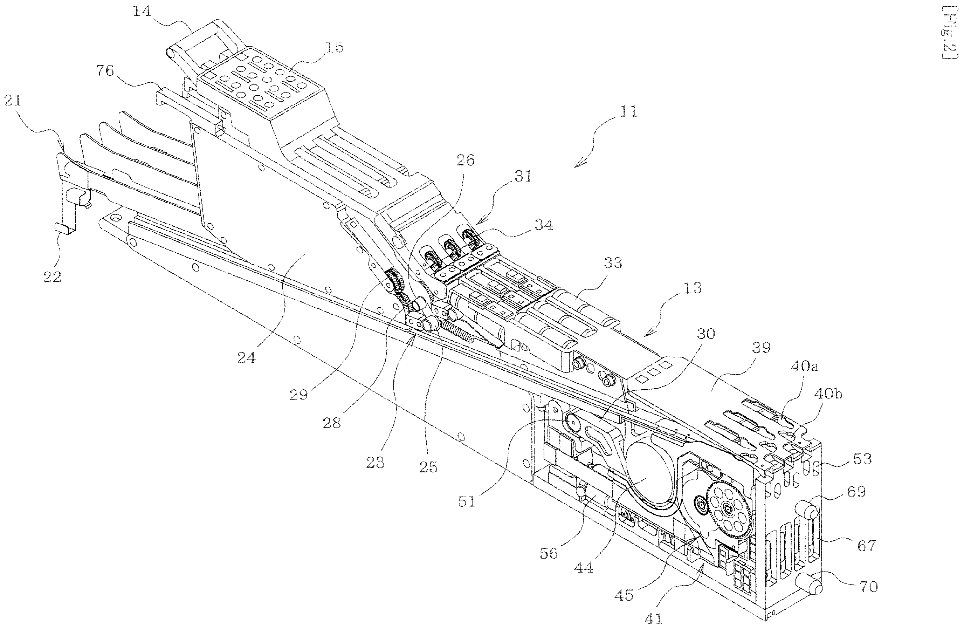

As shown in FIGS. 9, 10, and 12, raising and lowering lever 30 assembled to sprocket moving mechanism 45 of each sprocket moving unit 41 is assembled such that it can raise and lower sprocket 42 side around axis 51 as a fulcrum on unit base 50, with the configuration being such that raising and lowering is performed between an engagement position at which the teeth of sprocket 42 are engaged with the sprocket holes of component supply tape 12 and a retract position at which the teeth of sprocket 42 are a position lower than the sprocket holes of component supply tape 12. On the end surface of each sprocket moving unit 41, guide pins 52 for guiding the up and down movement are attached, and by engaging each guide pin 52 with each guide hole 53 (refer to FIG. 2) formed in the end surface of feeder main body 13, the range of possible up and down movement of each sprocket moving mechanism 45 is the range between the engagement position and retract position.

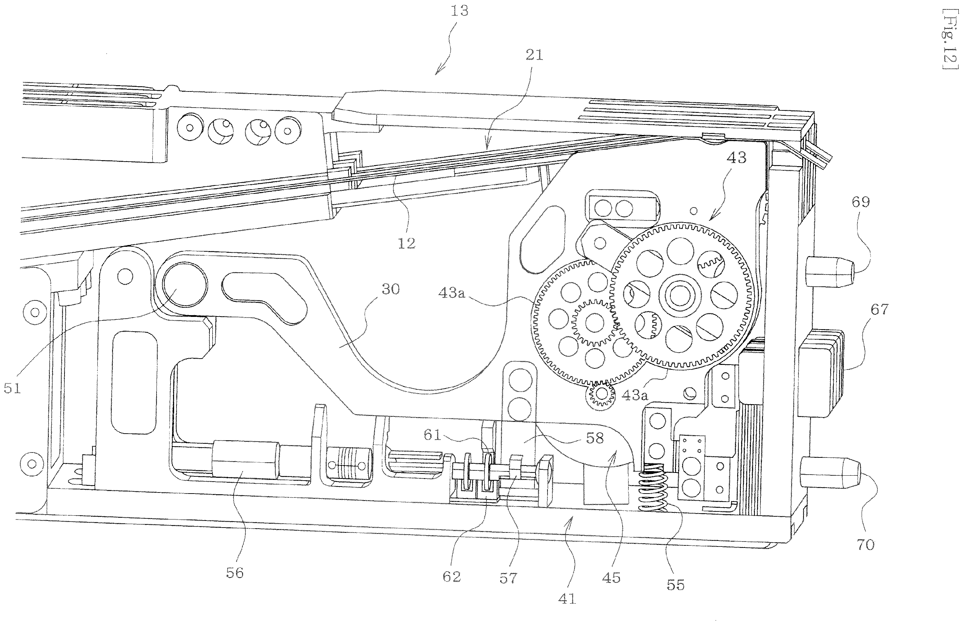

As shown in FIG. 12, each sprocket moving unit 41 is equipped with spring 55 used as a biasing means for biasing in the up direction the sprocket 42 side of sprocket moving mechanism 45 using axis 51 as a fulcrum, so that sprocket moving mechanism 45 can be kept in the upper position which is the engagement position by the elastic force of this spring 55. Each sprocket moving unit 41 is equipped with motor 56 acting as an actuator for opposing spring 55 and lowering sprocket moving mechanism 45.

Cams 57 are fixed to the rotating axis of each motor 56, and for these, on each sprocket moving mechanism 45, cam contacting material 58 such as in an L-shape to contact each cam 57 from below such is provided, and if motor 56 is rotated so that cam 57 rotates to the lowest point (or a point close to it), cam contacting material 58 and sprocket moving mechanism 45 oppose spring 55 as one body and are lowered and sprocket moving mechanism 45 is kept in the retract position which is the lowest position. Then, if motor 56 is rotated to the original position and cam 57 is returned to the highest position (or a point close to it), sprocket moving mechanism 45 is pushed up and kept at the engagement position, which is the highest position, by the elastic force of spring 55 which follows the movement of cam 57. In this case, if electricity to motor 56 is turned off so that moving power to motor 56 is canceled, it is also acceptable to push up sprocket moving mechanism 45 by the elastic force of spring 55.

The rotating axis of each motor 56 is equipped with position detection dog 61 for detecting the position of each cam 57, and for these, each sprocket moving unit 41 is equipped with cam position sensor 62 (a light sensor such as a photo-interrupter, non-contact sensor such as a magnetic sensor) for detecting each position detection dog 61, so that each cam position sensor 62 can be used to detect which position it is in, the engagement position (highest) or the retract position (lowest).

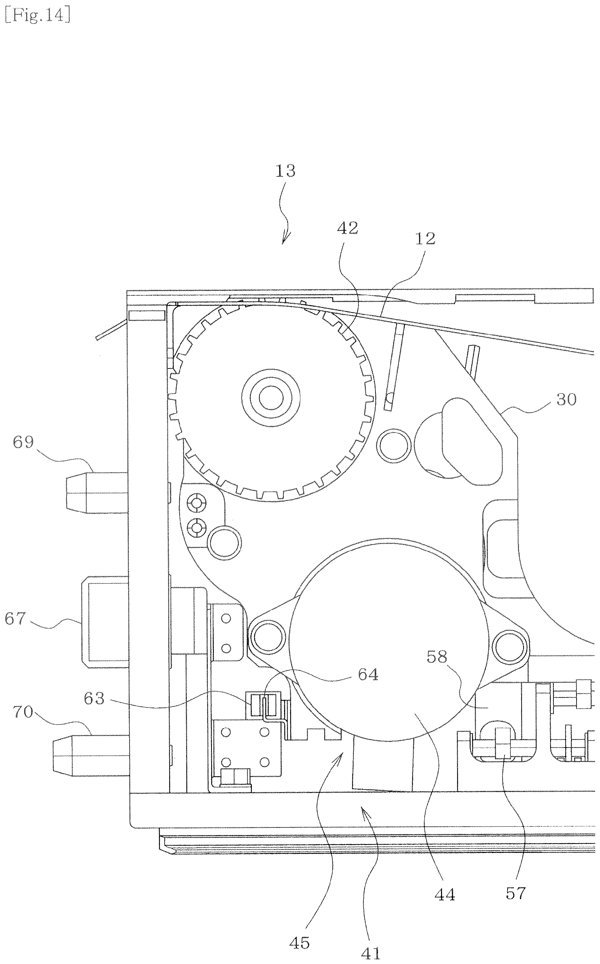

Also, as shown in FIG. 14, each sprocket moving unit 41 is equipped with engagement detection sensor 63 (a light sensor such as a photo-interrupter, non-contact sensor such as a magnetic sensor) as an engagement detecting means for detecting movement of sprocket 42 of sprocket moving mechanism 45 up to the engagement position. Each sprocket moving mechanism 45 is equipped with position detection dog 64 for detecting each engagement position, and if sprocket 42 is raised to the engagement position so that any of the sprocket teeth 42 of sprocket moving mechanism 45 are engaged in sprocket holes of component supply tape 12, with a configuration such that a detection signal is outputted as position detection dog 64 of sprocket moving mechanism 45 is detected by engagement detecting sensor 63.

In this case, the length of the teeth of sprocket 42 and positions of engagement detection sensor 63 and position detection dog 64 are set so that: when the teeth of sprocket 42 are engaged in the sprocket holes of component supply tape 12 which has the maximum thickness which can be set on tape feeder 11, engagement detecting sensor 63 detects position detection dog 64; and when the teeth of sprocket 42 are not engaged in the sprocket holes of component supply tape 12 which has the minimum thickness which can be set on tape feeder 11, engagement detecting sensor 63 does not detect position detection dog 64.

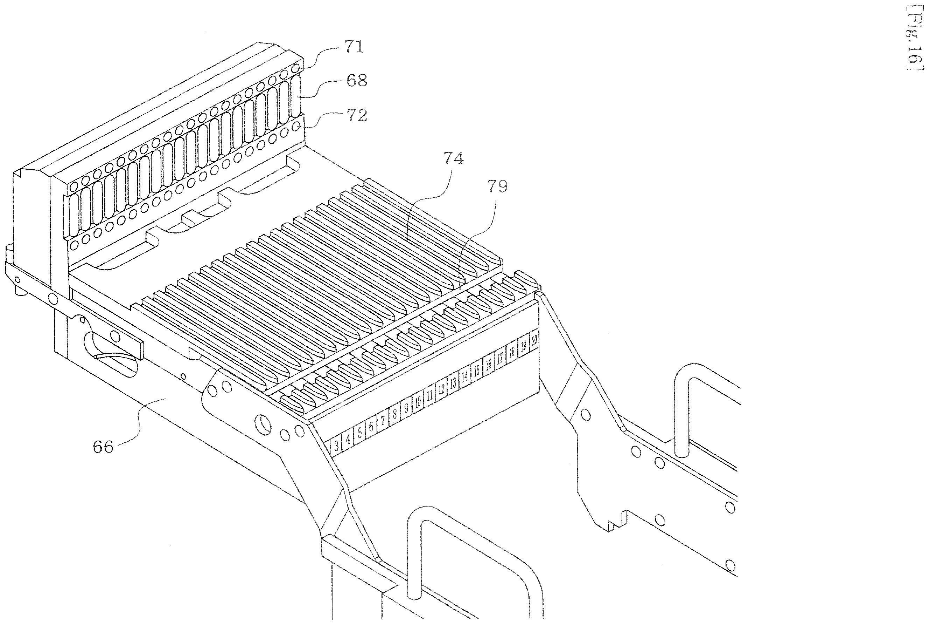

The front end of feeder main body 13 is equipped with connector 67 for connecting the signal wire and power wire of feeder main body 13 to connector 68 (refer to FIG. 16) of feeder loading table 66 of the electronic component mounter and 2 positioning pins 69 and 70; by inserting the 2 positioning pins 69 and 70 into positioning holes 71 and 72 (refer to FIG. 16) of feeder loading table 66 of the electronic component mounter, the attached position of feeder main body 13 on feeder loading table 66 can be decided, and connector 67 of feeder main body 13 is inserted into connector 68 of feeder loading table 66 so they are connected.

In order to support tape feeder 11 in an upright position, the upper surface of feeder loading table 66 is equipped with a guide groove which is a cross-section T-shaped groove, so that when the cross-section T-shaped guide rail (not shown) on the underside of feeder main body 13 is inserted into guide groove 74 from the front end, tape feeder 11 is supported in an upright position on feeder loading table 66; and by the clamping section (not shown) equipped on feeder main body 13 engaging with clamping groove 79 on feeder loading table 66 and pushing feeder main body 13 forward (towards connector 68 of feeder loading table 66) and clamping, the forward/back position of feeder main body 13 on feeder loading table 66 is decided and the feeder can be attached and removed.

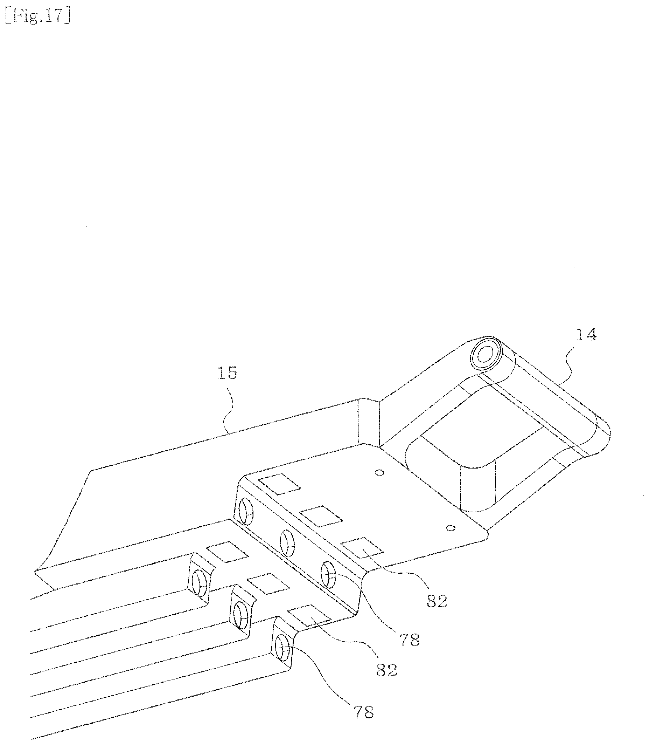

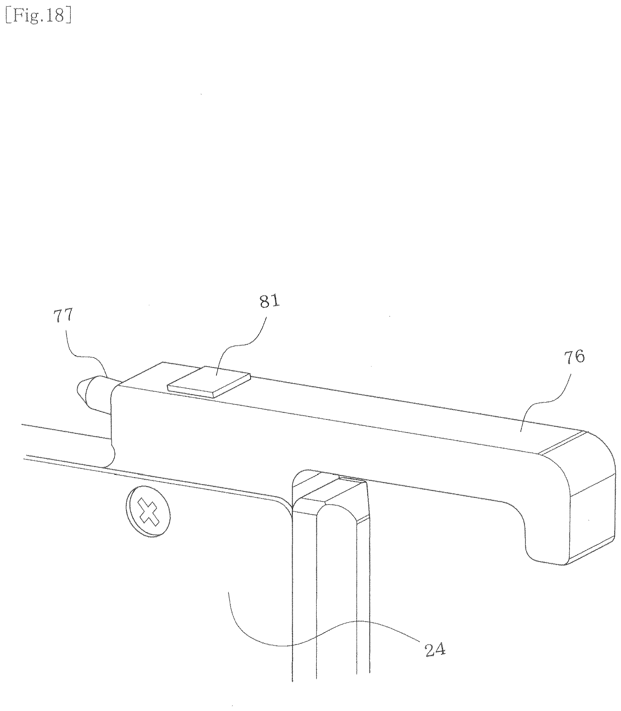

The upper end section of cover tape collection case 24 of each tape supplier 21 is equipped with handle 76, with each handle 76 being equipped with positioning pin 77 (refer to FIG. 18) on the front end. For these, on the lower stepped section of operation panel 15 of feeder main body 13 there are positioning holes 78 (refer to FIG. 17), and when tape supplier 21 is set on feeder main body 13 positioning pin 77 of handle 76 is inserted into positioning hole 78 on the underside of operation panel 15 so that the position of handle 76 is decided with respect to the underside of operation panel 15.

As shown in FIG. 18, as a supplier identification information memorizing means, RF tag 81 (also known as an electronic tag, IC tag, electromagnetic tag, wireless tag) with tape supplier 21 identification information (hereafter referred to as "supplier ID") memorized is attached to the upper surface of handle 76. It is also acceptable for information such as component information of component supply tape 12 to be memorized on RF tag 81 as well as the supplier ID, or instead of the supplier ID.

For this, the underside of operation panel 15 of feeder main body 13 is equipped with reader 82 (refer to FIG. 17) as an identification information reading and memorizing means for reading the supplier ID memorized in RF tag 81, so that when tape supplier 21 is set on feeder main body 13 and positioning pin 77 of handle 76 is inserted into positioning hole 78 on the underside of operation panel 15, RF tag 81 on the upper surface of handle 76 comes adjacent and opposite to reader 82 on the underside of operation panel 15, and the supplier ID memorized on RF tag 81 is read by reader 82.

The supplier ID signal outputted by this reader 82 is also used as the set confirmation signal of tape supplier 21 onto feeder main body 13, so that the setting of tape supplier 21 onto feeder main body 13 is confirmed by reading the supplier ID with reader 82. For the reader 82 arranged on the underside of operation panel 15, at least the antenna of reader 82 should be arranged; but it is acceptable for the control circuit section of reader 82 to be separated from the antenna and arranged on another section.

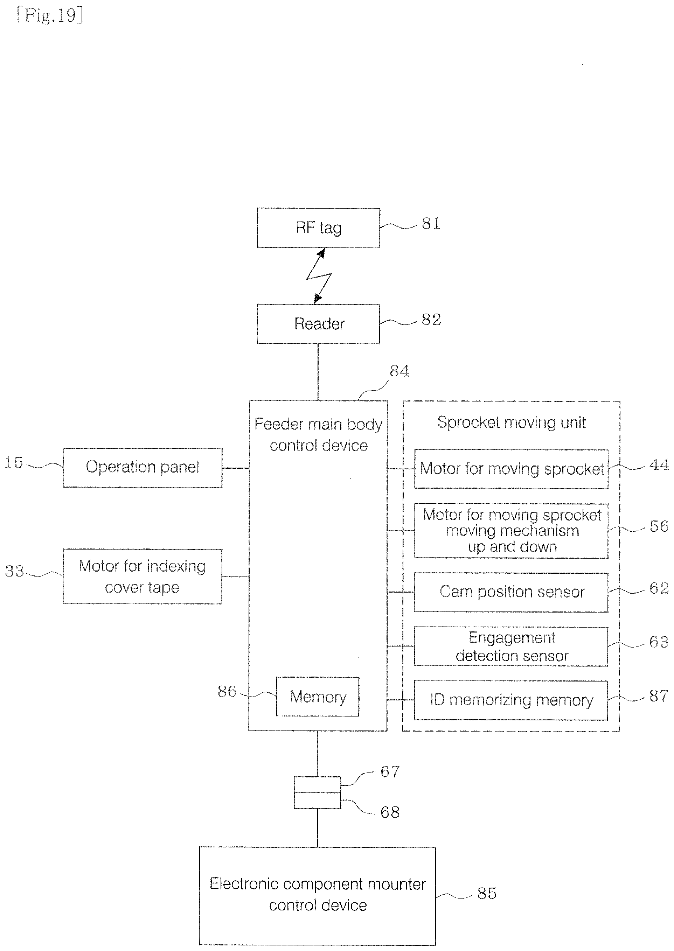

Also, as shown in FIG. 19, feeder main body 13 is equipped with control device 84 for controlling operation of items such as each motor 33, 44, and 56. This control device 84 is equipped with communication functionality (communication means), and the supplier ID read by reader 82 is sent to control device 84, and then sent from control device 84 to control device 85 of the electronic component mounter via connectors 67 and 68. Feeder main body 13 identification information (hereafter referred to as "feeder main body ID") is memorized in memory 86 (feeder main body identification information memorizing means) of control device 84 of feeder main body 13, and this feeder main body ID is also sent from control device 84 to control device 85 of the electronic component mounter via connectors 67 and 68.

Furthermore, each sprocket moving unit 41 is also equipped with ID memorizing memory 87 which memorizes the identification information of sprocket moving unit 41 (hereafter referred to as "the sprocket moving unit ID"), and control device 84 of feeder main body 13 reads the sprocket moving unit ID memorized in memory 87 for memorizing the ID of each sprocket moving unit 41 and sends it to control device 85 of the electronic component mounter. By this, control device 85 of electronic component mounter can manage individually tape suppliers 21, feeder main bodies 13, and sprocket moving units 41 by using the supplier ID, feeder main body ID, and sprocket moving unit ID.

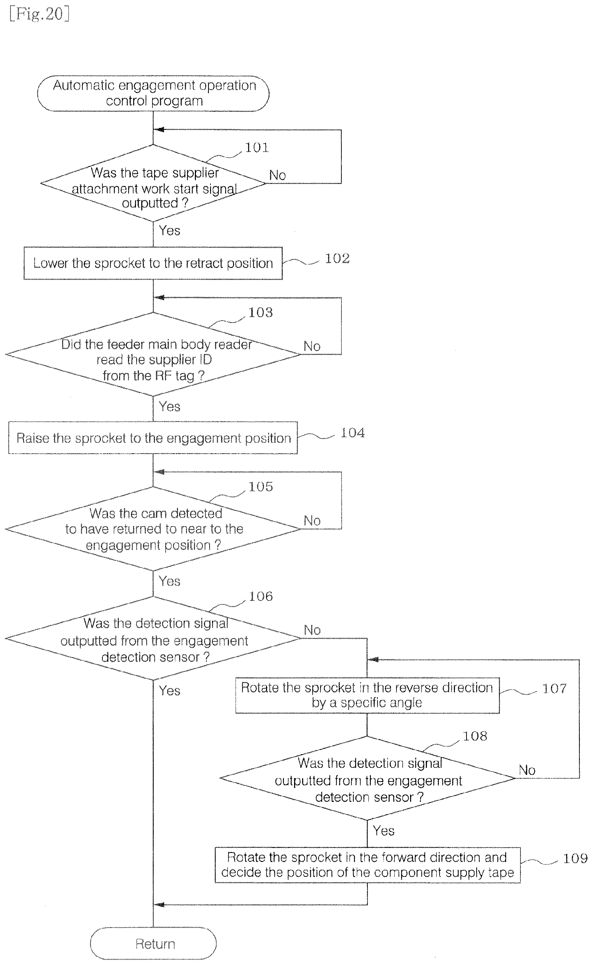

For control device 84 of feeder main body 13, by running the automatic engagement operation control program from FIG. 20 below, when tape supplier 21 is set on feeder main body 13, after sprocket 42 is automatically lowered to the retract position and component supply tape 12 is set above sprocket 42, motor 56 for moving the sprocket moving mechanism up and down is controlled so that sprocket 42 is raised to the engagement position; if control is performed to raise sprocket 42 to the engagement position but the teeth of sprocket 42 do not engage with the sprocket holes of component supply tape 12 and a detection signal is not output from engagement detection sensor 63, rotation of sprocket 42 via automatic engagement operation is performed whereby sprocket 42 is rotated by motor 44 until the teeth of sprocket 42 engage with the sprocket holes of component supply tape 12 and a detection signal is outputted by engagement detection sensor 63.

Below describes the internal processing of the automatic engagement operation control program from FIG. 20 which is run by control device 84 of feeder main body 13. The automatic engagement operation control program from FIG. 20 is run repeatedly for each sprocket moving unit 41 (each tape supplier 21) while electric power is supplied to control device 84 of feeder main body 13.

When this program is started, first, in step 101, a judgment is performed as to whether a tape supplier work start signal has been inputted (whether the operator pressed the attachment work start key on operation panel 15); if a tape supplier work start signal has been not been inputted yet, the program waits until a tape supplier work start signal is inputted.

After that, when a tape supplier work start signal is inputted, internal processing from step 102 onwards of the automatic engagement operation control program is run as follows. First, in step 102, motor 56 for moving the sprocket moving mechanism up and down is operated and sprocket moving mechanism 45 is lowered in opposition to spring 55, until sprocket 42 is lowered until the retract position.

After that, continuing to step 103, from whether reader 82 of feeder main body 13 reads the supplier ID from RF tag 81 of tape supplier 21, the program judges whether the operator has completed the work of attaching tape supplier 21 to feeder main body 13 (whether RF tag 81 of tape supplier 21 was placed in front of reader 82 of feeder main body 13); if reader 82 of feeder main body 13 has not read the supplier ID yet, the program waits until the supplier ID is read.

After that, when reader 82 of feeder main body 13 has read the supplier ID from RF tag 81 of tape supplier 21, the program judges that the operator has completed the work of attaching tape supplier 21 to feeder main body 13 and, continuing to step 104, by rotating motor 56 for raising and lowering the sprocket moving mechanism to its original position and returning cam 57 to the highest position (or a point close to it), after raising sprocket moving mechanism 45 to the engagement position by the elastic force of spring 55 which follows the movement of cam 57, turn the power to motor 56 off. In this case, if electricity to motor 56 for raising and lowering the sprocket moving mechanism is turned off so that moving power to motor 56 is canceled, it is also acceptable to raise sprocket moving mechanism 45 to the engagement position by the elastic force of spring 55. After that, continuing to step 105, the program judges whether cam position sensor 62 detected that cam 57 returned to near the engagement position (highest position); if cam 57 has not returned to the near the engagement position (highest position), the program waits until cam 57 returns to the engagement position (highest position). Alternatively, it is also acceptable to judge whether the specific time required for sprocket 42 to rise to the engagement position has elapsed; and if the specific time has not elapsed yet, to wait until the specific time has elapsed.

After that, when cam position sensor 62 detects that cam 57 has returned to near the engagement position (highest position) (or when the specific time has elapsed), continuing to step 106, by judging whether a detection signal has been outputted from engagement detection sensor 63, the program judges whether the teeth of sprocket 42 are engaged in the sprocket holes of component supply tape 12; and if a detection signal has been outputted from engagement detection sensor 63 it is judged that the teeth of sprocket 42 are engaged in the sprocket holes of component supply tape 12 and automatic engagement operation is completed. In this case, it is also desirable to rotate sprocket 42 an appropriate amount to decide the position of the first component in component supply tape 12 with respect to the component supply position.

With respect to this, in step 106 above, if it is judged that a detection signal has not been outputted from engagement detection sensor 63, the program judges that the teeth of sprocket 42 are not yet engaged with the sprocket holes of component supply tape 12 and, continuing to step 107, after rotating motor 44 in the reverse direction to rotate sprocket 42 in the reverse direction by a specific angle, continuing to step 108, the program judges whether a detection signal has been outputted from engagement detection sensor 63; if a detection signal has not been outputted yet, the program judges the teeth of sprocket 42 are not engaged with the sprocket holes of component supply tape 12 and the program returns to step 107 and repeats the processing of rotating motor 44 in the reverse direction to rotate sprocket 42 in the reverse direction by a specific angle. By this, processing is repeated to rotate sprocket 42 by a specific angle each time in the reverse direction using motor 44 until a detection signal is outputted from engagement detection sensor 63, and when a detection signal is output from engagement detection sensor 63, the program judges that the teeth of sprocket 42 are engaged in the sprocket holes of component supply tape 12 and, continuing to step 109, motor 44 is rotated forwards to rotate sprocket 42 forwards to decide the position of the first component in component supply tape 12 with respect to the component supply position and automatic engagement operation is completed.

With the embodiment described above, by equipping tape supplier 21 with RF tag 81 for memorizing the supplier ID, and equipping feeder body 13 with reader 82 for reading the supplier ID from RF tag 81 of tape supplier 21 attached to feeder main body 13, the supplier ID of tape supplier 21 attached to feeder body 13 can be automatically read by reader 82 on feeder main body 13, which can resolve problems caused by actions such as attaching the wrong tape supplier 21 or entering the wrong tape supplier ID.

Also, because with this embodiment the signal for the supplier ID read by reader 82 of feeder main body 13 reading the supplier ID from RF tag 81 of tape supplier 21 is also used as the confirmation signal for the attachment of tape supplier 21, it is not necessary to attach an item such as a sensor to confirm the attachment of tape supplier 21 on feeder main body 13, which can satisfy the demands of a simple configuration and reduced costs. It is also acceptable to use RF tag 81 as only an attachment confirmation sensor.

In addition, because the feeder main body ID is memorized on memory 86 of feeder main body 13 and the feeder main body ID read from memory 86 and the supplier ID read by reader 82 are sent to the electronic component mounter on which feeder main body 13 is attached, both the feeder main body ID and supplier ID can be managed at the electronic component mounter side.

Also, with the present embodiment, feeder main body 13 is configured such that multiple tape suppliers 21 are independently removably attached; and feeder main body 13 is equipped with multiple sprocket moving units 41 for the multiple tape suppliers 21 to be attached; and each sprocket moving unit 41 is equipped with ID memorizing memory 87 which memorizes each sprocket moving unit ID; and because the sprocket moving unit IDs read from the ID memorizing memory 87 which memorizes each sprocket moving unit ID are sent to the electronic component mounter side, the sprocket moving unit IDs can also be managed at the electronic component mounter side in addition to the supplier IDs and feeder main body IDs.

Also, with the present embodiment, when tape supplier 21 is set on feeder main body 13, even when performing control to raise sprocket 42 to the engagement position after lowering sprocket 42 to the retract position and setting component supply tape 12 above sprocket 42, if the teeth of sprocket 42 do not engage with the sprocket holes of component supply tape 12 and a detection signal is not outputted from engagement detection sensor 63, automatic engagement operation to rotate sprocket 42 is performed until sprocket 42 is rotated so that the teeth of sprocket 42 engage with the sprocket holes of component supply tape 12 and engagement detection sensor 63 outputs a detection signal; this means that at the same time as automating the work for engaging the teeth of sprocket 42 with the sprocket holes of component supply tape 12, it is possible to ensure correct engagement of the teeth of sprocket 42 with the sprocket holes of component supply tape 12 using the automatic engagement operation.

In this case, it is acceptable for the rotation direction of sprocket 42 during automatic engagement operation to be forward or reverse rotation, but if during automatic engagement operation the teeth of sprocket 42 are not engaged with the sprocket holes of component supply tape 12, because the teeth of sprocket 42 are rotated while contacting the lower surface of component supply tape 12 and component supply tape 12 moves shifted in the same direction as sprocket 42, if sprocket 42 is only rotated in the forward direction during automatic engagement operation, unwanted movement past the component pickup position (where pickup is not possible with the suction nozzle) for the first component in component supply tape 12 may occur.

Therefore, in the present embodiment, when automatic engagement operation is performed, because sprocket 42 is rotated in the forward direction to decide the position of component supply tape 12 after first rotating sprocket 42 in the reverse direction so the teeth of sprocket 42 engage with the sprocket holes of component supply tape 12 and a detection signal is outputted from engagement detection sensor 63, it is possible to prevent the first component in component supply tape 12 moving past the component pickup position during automatic engagement operation, and it is possible to decide the position for the component pickup position of the first component in component supply tape 12 after confirming that the teeth of sprocket 42 are engaged with the sprocket holes of component supply tape 12.

In addition, in the present embodiment, because the configuration is such that tape reel 16 and tape supplier 21 are removably attached to feeder main body 13, when changing component supply tape 12, with feeder main body 13 left attached to the electronic component mounter, after removing tape reel 16 and tape supplier 21 from feeder main body 13, with component supply tape pulled out from a new tape reel 16 set and held in tape supplier 21, if these are loaded onto feeder main body 13, the teeth of sprocket 42 can be automatically engaged with the sprocket holes of component supply tape 12 by the automatic engagement operation, and the changeover work for component supply tape 12 can be performed easily.

Also, in the present embodiment, as well as feeder main body 13 being equipped with multiple sprocket moving units 41, because the configuration is such that the teeth of sprocket 42 of each sprocket moving unit 41 can be engaged with the sprocket holes of component supply tape 12 supplied to each tape supplier 21 and multiple tape suppliers 21 are attached to feeder main body 13 so that they are independently attachable and removable, there is the benefit that it is possible to change to a new component supply tape 12 by removing only the component supply tape 12 which has run out of parts together with tape supplier 21 from feeder main body 13 from among the multiple component supply tapes 12 set on feeder main body 13 which is attached to feeder loading table 66 of the electronic component mounter.

However, for the present invention, it is also acceptable for feeder main body 13 to be equipped with only 1 sprocket moving unit 41, and for the configuration to be such that only 1 tape supplier 21 is removably attached to feeder main body 13.

For the above embodiment, feeder main body 13 is equipped with reel holder 17 for storing multiple tape reels 16 together, it is also acceptable to have a configuration in which each tape supplier 21 is equipped with a reel holder for storing each tape reel 16 separately.

In addition, the present invention is not limited to the above embodiment, and it goes without saying that it is possible to have an embodiment with various changes that does not extend beyond the scope of the invention; for example, the number of tape suppliers 21 (the number of sprocket moving units 41) which can be attached to and removed from feeder main body 13 could be changed, or it would be acceptable to have a configuration in which the sprocket moving mechanism is moved up and down by sliding movement and so on.

### Symbol descriptions

11. Tape feeder; 12. Component supply tape; 13. Feeder main body; 14. Handle; 15. Operation panel; 16. Tape reel; 17. Reel holder; 21. Tape supplier; 22. Reel hook; 23. Cover tape peeling device; 24. Cover tape collection case; 25. Peeling roller; 28, 29. Cover tape indexing gear; 31. Moving device; 33. Motor; 34. Moving gear; 37, 38. Tape retainer; 41. Sprocket moving unit; 42. Sprocket; 43. Spur gear set (gear mechanism); 43a. Cog; 44. Motor; 45. Sprocket moving mechanism; 46. Bearing; 47. Elastic material; 48. Bearing retainer; 49. Screw; 51. Axis; 52. Guide pin; 53. Guide hole; 55. Spring (biasing means); 56. Motor (actuator); 57. Cam; 58. Cam contacting material; 61. Position detection dog; 62. Cam position sensor; 63. Engagement detection sensor (engagement detecting means); 64. Position detection dog; 66. Feeder loading table; 67, 68. Connector; 69, 70. Positioning pin; 71, 72. Positioning holes; 74. Guide groove; 76. Handle; 77. Positioning pin; 78. Positioning hole; 81. RF tag (supplier identification information memorizing means); 82. Reader (identification information reading and memorizing means); 84. Feeder main control device (communication means); 85. Electronic component mounter control device; 86. Memory; 87. ID memorizing memory

## Claims

1. A tape feeder, wherein for a tape feeder (11) configured such that at least one tape supplier (21) on which component supply tape in which multiple electronic components are arranged at a specific pitch is set in order to supply the components to a pickup position is removably attached to a feeder main body (13); said tape supplier (21) is equipped with a supplier identification information memorizing means (81) in which said tape supplier identification information (hereafter referred to as "supplier ID") is memorized; said feeder main body (13) is equipped with an identification information reading and memorizing means (82) for reading said supplier ID from said supplier identification information memorizing means (81) of said tape supplier (21) attached to said feeder main body (13); said feeder main body (13) being equipped with an attachment recognition means to recognize when said tape supplier (21) has been attached to said feeder main body (13) by reading said supplier ID from said supplier identification information memorizing means (81) using said identification information reading and memorizing means (82), wherein the tape supplier (21) is equipped with a cover tape peeling device (23) for peeling away a cover tape which covers the upper surface of the component supply tape (12), and a cover tape collection case (24) for collecting cover tape peeled from component supply tape (12).

2. The tape feeder according to claim 1 **characterized in that** said feeder main body (13) is equipped with a feeder main body identification information memorizing means (86) for memorizing said identification information (hereafter referred to as "feeder main body ID") of said feeder main body (13); and a communication means for transmitting said supplier ID read by said identification information reading and memorizing means (82) and said feeder main body ID read from said feeder main body identification information memorizing means (86) to an electronic component mounter on which said feeder main body (13) is loaded.

3. The tape feeder according to claim 2 **characterized in that** said feeder main body (13) is configured such that multiple tape suppliers (21) can each be independently removably attached, and in which said feeder main body (13) is equipped with multiple sprocket moving units (41) comprising sprockets (42) with sprocket teeth for engaging holes of each component supply tape (12), the sprocket moving units being configured for moving the sprockets (42) and thereby indexing said component supply tape to a component pickup position for said multiple tape suppliers (21) to be attached, and for said each sprocket moving unit (41) to be equipped with a moving unit identification information memorizing means (87) which has memorized the identification information of the sprocket moving unit (41) (hereafter referred to as "the sprocket moving unit ID"), with said communication means transmitting said sprocket moving unit ID read from said moving unit identification information memorizing means (87) of said multiple sprocket moving units (41) to said electronic component mounter.

## Patentansprüche

1. Bandtransport-Vorrichtung, wobei für eine Bandtransport-Vorrichtung (11), die so ausgeführt ist, dass wenigstens eine Band-Zuführeinrichtung (21), in die Bauteil-Zuführband eingesetzt ist, an dem mehrere elektronische Bauteile in einem bestimmten Abstand angeordnet sind, um die Bauteile einer Aufnahme-Position zuzuführen, abnehmbar an einem Hauptkörper (13) der Transport-Vorrichtung angebracht ist, die Band-Zuführeinrichtung (21) mit einer Einrichtung (81) zum Speichern von Identifizierungs-Informationen der Zuführeinrichtung versehen ist, in der die Identifizierungs-Informationen der Band-Zuführeinrichtung (im Folgenden als "Zuführeinrichtungs-Kennung" bezeichnet) gespeichert sind, wobei der Hauptkörper (13) der Transport-Vorrichtung mit einer Einrichtung (82) zum Lesen und Speichern von Identifizierungs-Informationen versehen ist, mit der die Zuführeinrichtungs-Kennung aus der Einrichtung (81) zum Speichern von Identifizierungs-Informationen der Zuführeinrichtung der an dem Hauptkörper (13) der Transport-Vorrichtung angebrachten Band-Zuführeinrichtung (21) gelesen wird, der Hauptkörper (13) der Transport-Vorrichtung mit einer Anbringungs-Erkennungseinrichtung versehen ist, die erkennt, wenn die Band-Zuführeinrichtung (21) an dem Hauptkörper (13) der Transport-Vorrichtung angebracht worden ist, indem sie die Zuführeinrichtungs-Kennung unter Verwendung der Einrichtung (82) zum Lesen und Speichern von Identifizierungs-Informationen aus der Einrichtung (81) zum Speichern von Identifizierungs-Informationen der Zuführeinrichtung liest, und die Zuführeinrichtung (21) mit einer Abdeckband-Abziehvorrichtung (23), mit der ein Abdeckband abgezogen wird, das die obere Fläche des Bauteil-Zuführbandes (12) abdeckt, sowie mit einem Abdeckband-Sammelgehäuse (24) zum Sammeln von von dem Bauteil-Zuführband (12) abgezogenen Abdeckband versehen ist.

2. Bandtransport-Vorrichtung nach Anspruch 1, **dadurch gekennzeichnet, dass** der Hauptkörper (13) der Transport-Vorrichtung mit einer Einrichtung (86) zum Speichern von Identifizierungs-Informationen des Hauptkörpers der Transport-Vorrichtung, in der die Identifizierungs-Informationen des Hauptkörpers (13) der Transport-Vorrichtung (im Folgenden als "Kennung des Hauptkörpers der Transport-Vorrichtung" bezeichnet) gespeichert werden, sowie mit einer Kommunikationseinrichtung versehen ist, mit der die von der Einrichtung (82) zum Lesen und Speichern von Identifizierungs-Informationen gelesene Zuführeinrichtungs-Kennung und die aus der Einrichtung (86) zum Speichern von Identifizierungs-Informationen des Hauptkörpers der Transport-Vorrichtung gelesene Kennung des Hauptkörpers der Transport-Vorrichtung zu einer Elektronikbauteil-Bestückungseinrichtung übertragen werden, in die der Hauptkörper (13) der Transport-Vorrichtung eingesetzt ist.

3. Bandtransport-Vorrichtung nach Anspruch 2, **dadurch gekennzeichnet, dass** der Hauptkörper (13) der Transport-Vorrichtung so ausgeführt ist, dass mehrere Band-Zuführeinrichtungen (21) jeweils unabhängig abnehmbar angebracht werden können, und wobei der Hauptkörper (13) der Transport-Vorrichtung mit mehreren Transportrad-Bewegungseinheiten (41) versehen ist, die Transporträder (42) mit Transportzähnen umfassen, die mit Löchern jedes Bauteil-Zuführbandes (12) in Eingriff kommen, wobei die Transportrad-Bewegungseinheiten so ausgeführt sind, dass sie die Transporträder (42) bewegen und damit das Bauteil-Zuführband an eine Bauteil-Aufnahmeposition für die mehreren anzubringenden Band-Zuführeinrichtungen (21) weiterrücken, und dass jede Transportrad-Bewegungseinheit (41) mit einer Einrichtung (87) zum Speichern von Identifizierungs-Informationen der Bewegungseinheit versehen ist, die die Identifizierungs-Informationen der Transportrad-Bewegungseinheit (41) (im Folgenden als "Kennung der Transportrad-Bewegungseinheit" bezeichnet) gespeichert hat, wobei die Kommunikationseinrichtung die aus der Einrichtung (87) zum Speichern von Identifizierungs-Informationen der Transportrad-Bewegungseinheit der mehreren Transportrad-Bewegungseinheiten (41) gelesene Kennung der Transportrad-Bewegungseinheit zu der Elektronikbauteil-Bestückungseinrichtung überträgt.

## Revendications

1. Chargeur de bande, dans lequel le chargeur de bande (11) est configuré de telle sorte qu'au moins un alimenteur de bande (21), sur lequel est placée une bande d'alimentation de composants dans laquelle de multiples composants électroniques sont agencés avec un espacement spécifique de manière à alimenter les composants à une position de saisie, est attaché de manière amovible à un corps principal d'alimenteur (13) ; ledit alimenteur de bande (21) est équipé d'un moyen de mémorisation d'information d'identification d'alimenteur (81) dans lequel ladite information d'identification d'alimenteur de bande (désignée ci-après comme "identifiant d'alimenteur") est mémorisée ; ledit corps principal d'alimenteur (13) est équipé d'un moyen de lecture et de mémorisation d'information d'identification (82) pour lire ledit identifiant d'alimenteur sur ledit moyen de mémorisation d'information d'identification d'alimenteur (81) dudit alimenteur de bande (21) attaché audit corps principal d'alimenteur (13) ; ledit corps principal d'alimenteur (13) étant équipé d'un moyen de reconnaissance d'attachement pour reconnaître quand ledit alimenteur de bande (21) a été attaché audit corps principal d'alimenteur (13) en lisant ledit identifiant d'alimenteur sur ledit moyen de mémorisation d'information d'identification d'alimenteur (81) à l'aide dudit moyen de lecture et de mémorisation d'information d'identification (82), dans lequel l'alimenteur de bande (21) est équipé d'un dispositif de pelage de bande de recouvrement (23) pour éliminer une bande de recouvrement qui recouvre la surface supérieure de la bande d'alimentation de composants (12), et un boîtier de collecte de bande de recouvrement (24) pour collecter la bande de recouvrement pelée de la bande d'alimentation de composants (12).

2. Chargeur de bande selon la revendication 1, **caractérisé en ce que** ledit corps principal d'alimenteur (13) est équipé d'un moyen de mémorisation d'information d'identification du corps principal d'alimenteur (86) pour mémoriser ladite information d'identification (désignée ci-après comme "identifiant de corps principal d'alimenteur") dudit corps principal d'alimenteur (13) ; et un moyen de communication pour transmettre ledit identifiant d'alimenteur lu par ledit moyen de lecture et de mémorisation d'information d'identification (82) et ledit identifiant de corps principal d'alimenteur lu sur ledit moyen de lecture et de mémorisation d'information d'identification du corps principal d'alimenteur (86) à un monteur de composants électroniques sur lequel est chargé ledit corps principal d'alimenteur (13).

3. Chargeur de bande selon la revendication 2, **caractérisé en ce que** ledit corps principal d'alimenteur (13) est configuré de telle sorte que de multiples alimenteurs de bande (21) peuvent être attachés indépendamment de manière amovible, et dans lequel ledit corps principal d'alimenteur (13) est équipé de multiples unités de déplacement à pignons (41) comprenant des pignons (42) avec des dents de pignon destinées à s'engager dans des trous de chaque bande d'alimentation de composants (12), les unités de déplacement à pignons étant configurées pour déplacer les pignons (42) et indexer ainsi ladite bande d'alimentation de composants à une position de saisie de composants pour lesdits multiples alimenteurs de bande (21) à attacher, et pour chaque dite unité de déplacement à pignons (41) à équiper d'un moyen de mémorisation (87) d'information d'identification d'unité de déplacement qui a mémorisé l'information d'identification de l'unité de déplacement à pignons (41) (désignée ci-après comme "identifiant d'unité de déplacement à pignons"), ledit moyen de communication transmettant ledit identifiant d'unité de déplacement à pignons lu sur ledit moyen de mémorisation d'information d'identification d'unité de déplacement (87) desdites multiples unités de déplacement à pignons (41) audit monteur de composants électroniques.
